(19) Europäisches Patentamt

European Patent Office

Office européen des brevets

(11) **EP 0 772 273 B1**

(12) **EUROPEAN PATENT SPECIFICATION**

(45) Date of publication and mention
of the grant of the patent:
**29.08.2001 Bulletin 2001/35**

(51) Int Cl.⁷: $H02H\ 9/00$, $H03F\ 1/52$

(21) Application number: **95830458.6**

(22) Date of filing: **31.10.1995**

(54) **Sensor of the instant power dissipated in a power transistor**

Sofortleistungsverlustmesser in einem Leistungstransistor

Capteur de puissance dissipée instantanée d'un transistor de puissance

(84) Designated Contracting States:
**DE FR GB IT**

(43) Date of publication of application:
**07.05.1997 Bulletin 1997/19**

(73) Proprietor: **STMicroelectronics S.r.l.**
**20041 Agrate Brianza (Milano) (IT)**

(72) Inventor: **Chiozzi, Giorgio**
**I-20092 Cinisello Balsamo (Milano) (IT)**

(74) Representative: **Botti, Mario**
**Botti & Ferrari S.r.l.**
**Via Locatelli, 5**
**20124 Milano (IT)**

(56) References cited:
**EP-A- 0 058 005          GB-A- 2 214 745**
**US-A- 4 355 341**

EP 0 772 273 B1

## EP 0 772 273 B1

**Description**

This invention relates to protection devices for power elements included in integrated circuits, and specifically to devices for protecting final power transistors included in integrated circuits against outgoing overcurrents and overvoltages as may originate from shorts, for example.

The protection devices are integrated to the circuit which includes the power element to be protected, and accordingly, it should be possible to fabricate them using simple and economical technologies, it being further necessary that the protectors involve no losses of useful power as this may restrict the dynamic range of the power element.

In addition, such devices should be able to provide reliable protection of a high degree.

A conventional type of protection device that fills these demands has a circuit construction which includes at least one active element thermally coupled to the power element to be protected. This active element is connected to a control circuit means operative to turn off the integrated circuit to which the power element belongs upon the active element sensing a temperature level of danger, indicative of excessive power being dissipated due to a condition of overvoltage or overcurrent.

This conventional type of protection, while being effective and reliable, is unsuitable where the abnormal conditions of operation are only temporary since, lacking any external action, the device would remain off all the same.

It is for this reason that protectors are most frequently used which, although circuitally more complicated, have their cut-in threshold tied to the level of electrical quantities, i.e. current and voltage, that are related to the element to be protected, rather than to the level of heat dissipation. The level of such quantities is regulated to suit the dissipated instantaneous power, without the integrated circuit having to be turned off.

Such protection devices usually include circuit means for sensing and processing the value of the current flowing through the power element and of the voltage across it to produce, on a given threshold of values being exceeded, the activation of a threshold circuit, for example, so as to bring the current value through the power element down to a maximum value which would correspond to the threshold and be a function of the voltage value across the element.

The maximum value of the current which can flow through the power transistor without problems, and on which the sizing of the protection circuit would be dependent, is set by the physical characteristics of the same.

In general, for economical reasons, the users of integrated circuits that include power elements would size the external heat sinks for such elements to meet normal operation requirements, since short periods of large heat dissipation are well tolerated.

However, in a condition of protracted shorting, there exists a risk of the integrated circuit being damaged, and the surrounding material overheating and perhaps catching fire, from the heat generated and not adequately dissipated to the outside.

On the other hand, it would not be convenient to have the maximum current level through the power element decreased by lowering the cut-in threshold of the protection, because this would needlessly restrict the dynamic range of the circuit under normal operating conditions.

An example of a protection circuit of the type just outlined, for a power element in an integrated circuit, is disclosed in US Patent No. 4,623,950.

European patent application No. EP-A-0 058 005 describes a protection circuit for an output transistor in accordance with the preamble of claim 1, which produces a protecting signal representing the power consumption of the output transistor, namely the product of collector current and collector to emitter voltage of the output transistor, thereby protecting the output transistor over a broad operating range.

Since power transistors fail when their working point moves out of their Safe Operating Area (SOA), which SOA is largely limited by the maximum dissipable power, it is important to be able to accurately measure the instantaneous power being dissipated by the transistors, so as to ensure proper operation of the transistors and best utilization of their potential for dissipation. It is vitally important that this measurement be dependent on the smallest possible number of process parameters, and independent of temperature. The sensing circuit means employed heretofore actually provide coarse power measurements. In fact, they usually are affected by temperature and several process parameters, and do not allow full exploitation of the power transistors. A simple circuit is also of importance, whose design should allow for utmost reproducibility and minimal use of silicon area.

The underlying technical problem of this invention is to provide a sensing circuit (or sensor) for sensing the instantaneous power dissipated through a power transistor in an integrated circuit, which while having a simple construction and using up but a minimal amount of integration area, affords much improved measuring accuracy over conventional sensing circuits, so that full use of the transistor dynamic range can be made.

This problem is solved by a circuit for sensing the dissipated instantaneous power as defined in claim 1.

The features and advantages of a sensor according to this invention will be apparent from the following description of an embodiment thereof, given by way of example and not of limitation with reference to the accompanying drawings.

In the drawings:

Figure 1 shows a basis circuit diagram of an instantaneous power sensor;
Figure 2 shows the circuit diagram of an improved power sensor, according to the invention, for a power transistor;
Figure 3 illustrates a further improvement on the circuit diagram of Figure 2.

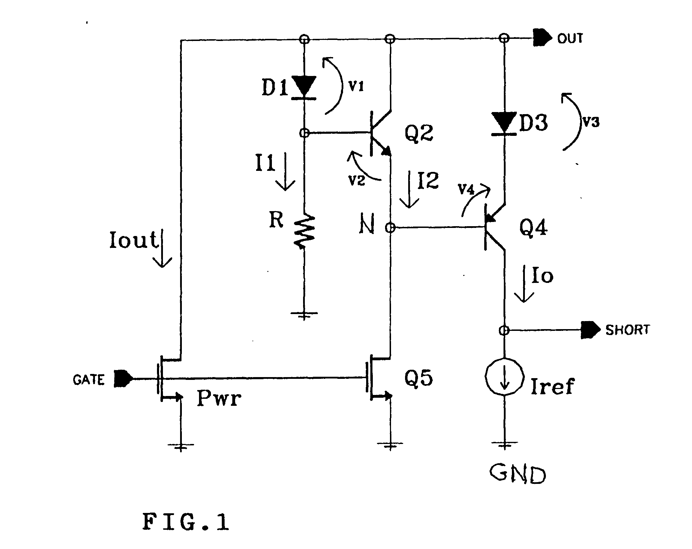

Shown in Figure 1 is a circuit diagram of a sensor adapted to sense the instantaneous power dissipated through a power transistor, in this case a power transistor Pwr of the N-channel MOS type, as commonly used in a lower half-stage of a push-pull final power stage.

A typical application would be to audio power amplifiers arranged for driving loudspeakers.

The power transistor Pwr is connected by its drain and source terminals, respectively, between the output terminal OUT of the stage and ground.

Omitted from the simplified diagram of Figure 1, are control and bias circuit means which may be those normally used by the person skilled in the art, and are supplied, through the output terminal SHORT of the sensor, with information about the instantaneous power being dissipated by the power transistor, which information can be conventionally processed by such circuit means to protect the power element in all situations, without needlessly restricting its dynamic range.

The sensing circuit comprises a bipolar transistor Q4 of the PNP type which has its emitter terminal coupled to the output terminal OUT of the stage through a diode D3, and its collector terminal coupled to ground through a reference current generator Iref.

The output terminal SHORT of the sensor is connected to a circuit node between the transistor Q4 and the current generator Iref.

Connected to the output terminal of the stage is a current mirror circuit, of which a first leg includes a diode D1 and a resistor R and is connected between the terminal OUT and ground, while the second leg includes a bipolar transistor Q2 of the NPN type which is connected by its collector and emitter terminals, respectively, between the terminal OUT and a circuit node N to which the base terminal of the transistor Q4 is connected.

As shown in Figure 1, the sensor further comprises a transistor Q5 which is of the N-channel MOS type, like the power transistor, and is driven (in this case through a common terminal GATE) in the same manner as the power transistor.

The transistor Q5 has its source and drain terminals respectively connected to ground and to the circuit node N.

The transistors Pwr and Q5 are applied the same gate voltage, and they can be operated in the same conditions of bias. Furthermore, the transistor Q5 can be much smaller than the power transistor and be integrated in tight thermal connection thereto.

The manner how the instantaneous power dissipated through the power transistor Pwr is sensed will now be discussed.

The voltage drop across the diode D1 is

$$V_1 = V_t \ln \frac{I_1 + \frac{I_2}{\beta}}{I_{s1}} \tag{1}$$

and that across the base-emitter junction of Q2 is

$$V_2 = V_t \ln \frac{I_2}{I_{s2}} \tag{2}$$

while the collector current of Q4 is

$$I_o = I_{s4} \exp \frac{V_4}{V_t} = I_{s3} \exp \frac{V_3}{V_t} \tag{3}$$

The voltage $V_3$ across D3 can be obtained from (3) above, by equating the logarithms of the second and third terms and solving for $V_3$, thus:

$$V_3 = \frac{V_t}{2} \ln \left[ \frac{I_{s4}\left(I_1 I_2 + \dfrac{I_2^2}{\beta}\right)}{I_{s1} I_{s2} I_{s3}} \right] \quad (4)$$

Substituting the expression (4) in (3), the following expression for the output current is obtained

$$I_0 = \sqrt{\frac{I_{s3} I_{s4}}{I_{s1} I_{s2}}} \sqrt{I_1 I_2 + \frac{I_2^2}{\beta}} \quad (5)$$

It can be seen that the current flowing through the transistor Q5 "mirrors" the current passed from the power transistor Pwr, and that $I_1$ is proportional to the drain-source voltage:

$$I_1 = \frac{V_{ds} - V_{be}}{R} \; ; \; I_2 = \frac{\left(\dfrac{W}{L}\right)_5}{\left(\dfrac{W}{L}\right)_{pwr}} I_{out} \quad (6)$$

Taking equation (6), and since the dissipated instantaneous power is $P_{diss} = I_{out} V_{ds}$, (5) can be re-written as follows:

$$I_0 = \sqrt{\frac{I_{s3} I_{s4}}{I_{s1} I_{s2}} \frac{1}{R} \frac{\left(\dfrac{W}{L}\right)_5}{\left(\dfrac{W}{L}\right)_{pwr}}} \sqrt{P_{diss}\left(1 - \frac{V_{be}}{V_{ds}}\right) + \frac{P_{diss}^2}{V_{out}^2} \frac{R}{\beta} \frac{\left(\dfrac{W}{L}\right)_5}{\left(\dfrac{W}{L}\right)_{pwr}}} \quad (7)$$

The last term under the root line in (7) takes account of the contribution from the base current of Q2 which, however, is small. Thus (7) becomes, as a coarse approximation

$$I_0 = \sqrt{\frac{I_{s3} I_{s4}}{I_{s1} I_{s2}} \frac{1}{R} \frac{\left(\dfrac{W}{L}\right)_5}{\left(\dfrac{W}{L}\right)_{pwr}}} \sqrt{P_{diss}\left(1 - \frac{V_{be}}{V_{ds}}\right)} = K \sqrt{P_{diss}\left(1 - \frac{V_{be}}{V_{ds}}\right)} \cong K\sqrt{P_{diss}} \quad (8)$$

It has been shown that, if the base current of Q2 and the voltage drop across the diode D1 are neglected, the outgoing current from the collector of the transistor Q4 is proportional to the square root of the power dissipated through the power transistor. With the maximum dissipable power being known, (8) gives the value setting for the reference current generator Iref.

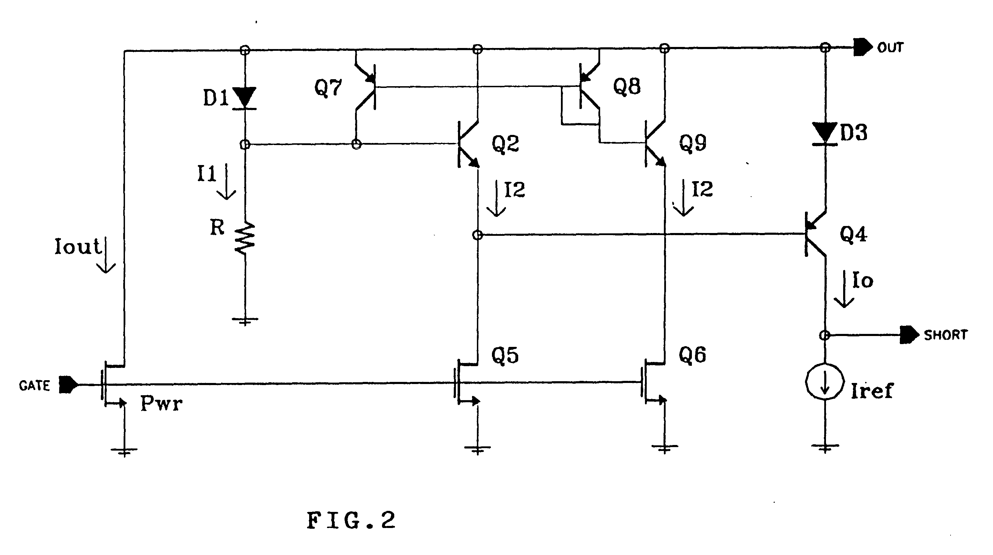

Compared to the circuit shown in Figure 1, the circuit according to the invention shown in Figure 2 recovers the contribution from the base current of Q2, which is of interest where this contribution is a significant one (as may happen especially at low values of $V_{ds}$ and if the $(W/L)_5/(W/L)_{pwr}$ ratio is too high): Q6 must be identical with Q5, so as to generate the same current $I_2$; the current mirror formed of Q7 and Q8 recovers the base current of Q9, which is the same as that of Q2; in fact, Q2 and Q9 should have the same dimensions, so as to have the base currents exactly equated. In this case, the collector current of Q4 would be

$$I_{Q4} = K\sqrt{P_{diss}\left(1 - \frac{V_{be}}{V_{ds}}\right)} \cong K\sqrt{P_{diss}} \qquad (9)$$

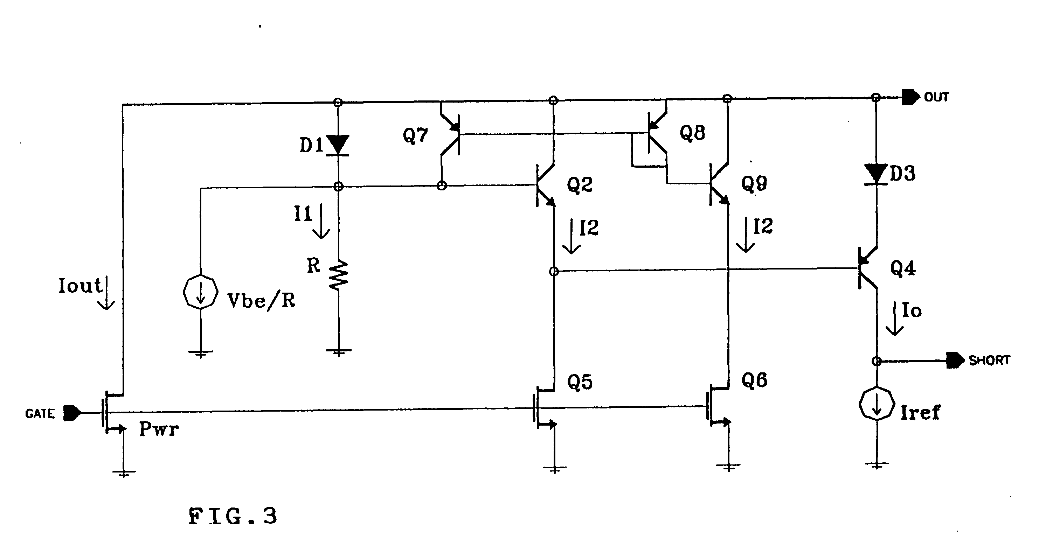

Figure 3 shows how the voltage drop across the diode DI can be recovered in order to obtain an accurate measurement of the power dissipated by the power transistor, even at low values of $V_{ds}$. The additional current generator in parallel with R should generate a current equal to the voltage across the diode divided by the value of the resistor R, i.e. the same as is used to sense the voltage $V_{ds}$.

The major advantages to be derived from the inventive circuit can be summarized as follows:

very accurate measurement of the instantaneous power dissipated by the power transistor;

simple circuit and minimal use of silicon area.

It should be understood that modifications, integrations and substitutions of elements may be made unto the embodiment described in the foregoing, without departing from the protection scope of the appended claims.

## Claims

1. A sensing circuit for sensing the instantaneous power dissipated through a power transistor (Pwr) in an integrated circuit, said power transistor (Pwr) having a first terminal which is coupled to a potential reference (GND), a second terminal which forms an output terminal (OUT) of a power stage, and a control terminal (GATE) which is coupled to a circuit means for controlling and biasing the stage, comprising first (Q4) and second (Q5) transistors, each having first and second terminals and a control terminal, and a first current mirror circuit (D1, R, Q2) having a first leg which includes a resistive element (R) and is connected between said output terminal (OUT) of the stage and the potential reference (GND), and a second leg connected between said output terminal (OUT) and a circuit node to which the control terminal of the first transistor (Q4) is connected, the first terminal of the first transistor (Q4) being coupled to said output terminal (OUT) of the stage through a diode (D3), the second terminal of the first transistor (Q4) being connected to a terminal for connection to the stage control and bias circuit means, and the second transistor (Q5) having its first and second terminals connected between the potential reference (GND) and said circuit node and its control terminal connected to the control terminal (GATE) of the power transistor (Pwr), **characterized in that** the second terminal of the first transistor (Q4) is also connected to the potential reference (GND) through a current generator ($I_{ref}$) and in that the sensing circuit further comprises third (Q9) and fourth (Q6) transistors, each having first and second terminals and a control terminal, said third (Q9) and fourth (Q6) transistors being connected in series between the output terminal (OUT) of the stage and the potential reference (GND), the fourth transistor (Q6) being identical with the second transistor (Q5) and having its control terminal connected to the control terminal (GATE) of the power transistor (Pwr), and a second current mirror circuit (Q7, Q8), having a first leg connected between the output (OUT) terminal of the stage and the control terminal of the third transistor (Q9), and a second leg connected between the output terminal (OUT) of the stage and said resistive element (R).

2. A sensing circuit according to Claim 1, **characterized in that** the power transistor (Pwr) and the second (Q5) and fourth (Q6) transistors are of MOS type, and the other transistors of bipolar type.

## Patentansprüche

1. Sensorschaltung zum Erfassen der momentanen Verlustleistung in einem Leistungstransistor (Pwr) einer integrierten Schaltung, wobei der Leistungstransistor (Pwr) einen ersten Anschluss aufweist, der mit einem Bezugspotential (GND) gekoppelt ist, einen zweiten Anschluss aufweist, der einen Ausgangsanschluss (OUT) einer Leistungsstufe bildet, und einen Steueranschluss (GATE) aufweist, der an eine Schaltungseinrichtung zum Steuern und Vorspannen der Stufe gekoppelt ist, umfassend einen ersten (Q4) und einen zweiten (Q5) Transistor, die jeweils einen ersten und einen zweiten Anschluss sowie einen Steueranschluss besitzen, und eine erste Stromspiegelschaltung (D1, R, Q2) mit einem ersten Zweig, der ein ohm'sches Element (R) enthält und zwischen dem Ausgangsanschluss (OUT) der Stufe und dem Bezugspotential (GND) liegt, und einen zweiten Zweig aufweist, der zwischen den Ausgangsanschluss (OUT) und einem Schaltungsknoten liegt, an den der Steueranschluss des ersten Transistors (Q4) gekoppelt ist, wobei der erste Anschluss des ersten Transistors (Q4) an den Ausgangsanschluss (OUT) der Stufe über eine Diode (D3) gekoppelt ist, der zweite Anschluss des ersten Transistors (Q4) an einen Anschluss für die Verbindung mit der Stufensteuer- und Vorspannungsschaltungseinrichtung gekoppelt ist, und der zweite Transistor (Q5) mit seinem ersten und seinem zweiten Anschluss zwischen dem Bezugspotential (GND) und dem Schaltungsknoten liegt, wobei sein Steueranschluss an den Steueranschluss (GATE) des Leistungstransistors (Pwr) gekoppelt ist, **dadurch gekennzeichnet**, dass der zweite Anschluss des ersten Transistors (Q4) außerdem über eine Stromquelle ($I_{ref}$) an das Bezugspotential (GND) gekoppelt ist, und dass die Sensorschaltung außerdem aufweist: einen dritten (Q9) und einen vierten (Q6) Transistor, jeweils mit einem ersten und einem zweiten Anschluss sowie einem Steueranschluss, wobei der dritte (Q9) und der vierte (Q6) Transistor in Reihe zwischen den Augangsanschluss (OUT) der Stufe und das Bezugspotential (GND) geschaltet sind, der vierte Transistor (Q6) identisch mit dem zweiten Transistor (Q5) ist und mit seinem Steueranschluss an den Steueranschluss (GATE) des Leistungstransistors (Pwr) gekoppelt ist, und eine zweite Stromspiegelschaltung (Q7, Q8) vorgesehen ist, die mit einem ersten Zweig zwischen dem Ausgangsanschluss (OUT) der Stufe und dem Steueranschluss des dritten Transistors (Q9) liegt, und mit einem zweiten Zweig zwischen dem Ausgangsanschluss (OUT) der Stufe und dem ohmschen Element (R) liegt.

2. Sensorschaltung nach Anspruch 1, **dadurch gekennzeichnet**, dass der Leistungstransistor (Pwr) und der zweite (Q5) und der vierte (Q6) Transistor vom MOS-Typ sind, während die übrigen Transistoren Bipolar-Transistoren sind.

## Revendications

1. Circuit de détection permettant de détecter la puissance dissipée instantanée d'un transistor de puissance (Pwr) dans un circuit intégré, ledit transistor de puissance (Pwr) ayant une première borne reliée à un potentiel de référence (GND), une deuxième borne formant une borne de sortie (OUT) d'un étage de puissance, et une borne de commande (GRILLE) reliée à des moyens formant un circuit permettant de commander et de polariser l'étage, comprenant des premier (Q4) et deuxième (Q5) transistors, ayant chacun des première et deuxième bornes et une borne de commande, et un premier circuit formant un miroir de courant (DI, R, Q2) ayant une première branche qui comporte un élément résistif (R) et qui est connectée entre ladite borne de sortie (OUT) de l'étage et le potentiel de référence (GND), et une deuxième branche connectée entre ladite borne de sortie (OUT) et un noeud de circuit auquel est connectée la borne de commande du premier transistor (Q4), la première borne du premier transistor (Q4) étant reliée à ladite borne de sortie (OUT) de l'étage par une diode (D3), la deuxième borne du premier transistor (Q4) étant connectée à une borne pour une connexion à des moyens de commande de l'étage et de polarisation, et les première et deuxième bornes du deuxième transistor (Q5) étant connectées entre le potentiel de référence (GND) et ledit noeud de circuit et sa borne de commande étant connectée à la borne de commande (GRILLE) du transistor de puissance (Pwr), **caractérisé en ce que** la deuxième borne du premier transistor (Q4) est également connectée au potentiel de référence (GND) par un générateur de courant (Iref) et en ce que le circuit de détection comprend en outre des troisième (Q9) et quatrième (Q6) transistors ayant chacun des première et deuxième bornes et une borne de commande, lesdits troisième (Q9) et quatrième (Q6) transistors étant connectés en série entre la borne de sortie (OUT) de l'étage et le potentiel de référence (GND), le quatrième transistor (Q6) étant identique au deuxième transistor (Q5) et ayant sa borne de commande connectée à la borne de commande (GRILLE) du transistor de puissance (Pwr), et un deuxième circuit formant un miroir de courant (Q7, Q8) ayant une première branche connectée entre la borne de sortie (OUT) de l'étage et la borne de commande du troisième transistor (Q9) et une deuxième branche connectée entre la borne de sortie (OUT) de l'étage et ledit élément résistif (R).

2. Circuit de détection selon la revendication 1, **caractérisé en ce que** le transistor de puissance (Pwr) et les deuxième (Q5) et quatrième (Q6) transistors sont du type MOS et en ce que les autres transistors sont du type bipolaire.

FIG.1

EP 0 772 273 B1

FIG.2

FIG.3

EP 0 772 273 B1